Europäisches Patentamt

European Patent Office

Office européen des brevets

(19)

(11) EP 1 630 857 A1

(12) EUROPEAN PATENT APPLICATION
published in accordance with Art. 158(3) EPC

(43) Date of publication:
01.03.2006 Bulletin 2006/09

(51) Int Cl.:
H01L 21/027 (1990.01)  G01B 11/00 (1968.09)

(21) Application number: 04745382.4

(22) Date of filing: 27.05.2004

(86) International application number:
PCT/JP2004/007276

(87) International publication number:
WO 2004/107415 (09.12.2004 Gazette 2004/50)

(84) Designated Contracting States:
AT BE BG CH CY CZ DE DK EE ES FI FR GB GR
HU IE IT LI LU MC NL PL PT RO SE SI SK TR

(30) Priority: 28.05.2003 JP 2003151703

(71) Applicant: NIKON CORPORATION
Tokyo 100-8331 (JP)

(72) Inventor: NAKAJIMA, Shinichi
c/o Nikon Corporation
Chiyoda,
Tokyo 100-8331 (JP)

(74) Representative: Amery, Marcus James et al
Albihns GmbH
Bayerstrasse 83
80335 München (DE)

(54) **POSITION INFORMATION MEASURING METHOD AND DEVICE, AND EXPOSURE METHOD AND SYSTEM**

(57)    A position information measuring method capable of easily obtaining information on a relative position deviation between two marks by using scatterometry or reflectometry. Marks (25A) are formed on a wafer (W) at a pitch P1, and marks (28A) are formed on an intermediate layer (27) over them at a pitch P2 different from the pitch P1. A detection light (DL) is allowed to vertically enter the wafer (W) and a regular reflection light (22) from two marks (25A, 28A) only is spectrally separated on a wavelength basis for photoelectric converting. Wavelength-based reflectances are obtained from obtained detection signals, a reflectance at a specified wavelength is determined for each position in the measuring direction (X direction) of marks (25A, 28A), the shape of a Moire pattern formed by the overlapping of two marks (25A, 28A) is determined from the obtained reflectance distribution, and the position deviation amount of a mark (28A) is determined from the shape.

Fig. 3

EP 1 630 857 A1

**Description**

Technical Field

The present invention relates to method and device for measuring positional information, or for obtaining information on the relative displacement of two marks, using the so-called scatterometry or reflectometry. The method and device are suitable for use for example in evaluating the alignment of the mask and the circuit board in the exposure process in which the mask pattern of any device such as a semiconductor element, an image pickup element (such as CCD), or a display element (such as a liquid crystal display element) is transferred onto a substrate. The method and device are also suitable for evaluating the overlay error after the exposure.

Background Art

For example in the exposure step of the lithography process for manufacturing semiconductor elements and liquid crystal display elements, an exposure device such as a stepper is used to project by exposure the image of a fine pattern formed on a reticle (or photo-mask, etc.) serving as a mask onto a semiconductor wafer (or glass plate, etc.) serving as a substrate on which a photosensitive material such as a photo-resist is applied. Since it is necessary to form complicated circuits on the wafer in specified positional relationship across many layers, when exposure is made to the second and succeeding layers, the reticle pattern image is exposed in the state of the reticle pattern image being positioned (aligned) with high accuracy to the circuit pattern previously formed in respective shot areas on the wafer according to the detected result of alignment mark positions on the reticle and wafer. As the requirement of alignment accuracy becomes severer along with increased degree of fineness of the pattern, various contrivances have been made.

For detecting the alignment mark on the reticle (reticle alignment), a VRA (visual reticle alignment) method has so far been used, in which the mark position is measured by processing the image data of the mark photographed with a CCD camera using exposure light (Refer to for example Japanese patent application publication laid-open No. 7-176468). On the other hand, for detecting the alignment mark on the wafer (wafer alignment), an FIA (field image alignment) method has so far been in use, in which the mark position is measured by processing the image data of the mark photographed with a CCD camera (Refer to for example Japanese patent application publication laid-open No. 7-183186). Other methods have also been in use: One is an LSA (laser step alignment) method in which laser beam is irradiated to a dotted-line-like mark on the wafer, and the mark position is detected using light diffracted or dispersed with the mark. Another is an LIA (laser interferometric alignment) method in which laser beams made to be slightly different in frequency are irradiated along two directions at a diffraction-grating-like pattern, resultant two diffracted light beams are made to interfere, and the mark position is measured from the phase of the interference light beam.

As a device for evaluating the alignment accuracy, an overlay error measuring device has so far been in use. This device uses an optical system of a great numerical aperture like that of the FIA method to simultaneously photograph the marks on the first and second layers, and their relative displacement amount is measured from the obtained image data. However, with such a method in which the mark images are formed using the optical system of the great numerical aperture, there is a possibility of measurement error occurring as affected with the aberration in the optical system or distortion of the marks. Further, there is another possibility of poor reproducibility of the measurement results as influenced by vibration or the like of the test object on which the marks are formed.

Therefore, a method using the so-called scatterometry has been proposed recently as a method for measuring the overlay error because the method in principle is less affected with the optical system aberration, mark distortion, test object vibration, etc. The method using the scatterometry is the one in which detection light of a specified band width is irradiated at measurement objects or marks on two layers, diffracted light of specified one order generated from those marks or light beam in specified one direction (reflected light, etc.) is separated by wavelength and detected, and the amount of relative displacement between the marks on the two layers is determined using the measurement results such as the determined reflectance or transmittance (spectral reflectance or spectral transmittance) by wavelength. A type of this method in which the detection light is cast vertically at the marks on the two layers to receive regular reflection light from those marks is also called as reflectometry.

With a method of measuring the overlay error using the scatterometry that has been proposed of late, a pair of first and second marks of the same pitch are formed close to each other in the measurement direction on the first and second layers, and relative displacement amounts of +1/4 pitch and -1/4 pitch are given in design to the pair of first and second marks (For example, refer to the non-patent document 1). Here, in case a displacement of the second layer relative to the first layer is present, it is possible to measure the amount of the relative displacement of the second layer according to the measurement results of spectral reflectance of the light beam from those marks by utilizing the fact that the absolute values of the relative displacement amounts of the pair of first and second marks change in opposite directions.

Non-Patent Document 1

H. Huang, G. Raghavendra, A. Sezginer, K. Johnson, F. Stanke, M. Zimmerman, C. Cheung, M. Miyagi and B. Singh, "Scatterometry-Based Overlay Metrology", Metrology, Inspection, and Process Control for Microlithography, SPIE (the United States), Bellingham, 2003, Vol. 5038, p. 132-143.

Disclosure of the Invention

Problems to be solved by the Invention

As described above, the method of measuring the overlay error using the scatterometry (or refletometry) requires only the detection of the light beam produced substantially in one direction such as diffracted light of specified one order or regular reflection light. Therefore, it is superior in principle to the image-forming method of the conventional FIA type in terms of such points as: possibility of using a simple optical system of a small numerical aperture, very little influence of aberration of the optical system, and very little influence of the mark distortion.
With the measuring method using the conventional scatterometry, however, because the relative displacement amount is obtained from the measurement results of the spectral reflectance of light beams from one pair of marks displaced by a design value of +1/4 pitch and from the other pair of marks displaced by a design value of -1/4 pitch, it is necessary to obtain in advance the relationship (factor of proportionality) between the variation amount of the spectral reflectance and the relative displacement amount. Therefore, there is a drawback that cumbersome preparatory steps (training steps) are required to obtain the relationship by actually measuring the spectral reflectance on a large number of samples of different relative displacement amounts for the second layer relative to that for the first layer. There is another drawback that, since the relationship between the variation amount of the spectral reflectance and the relative displacement varies with the layer and with the constitution of the mark, the preparatory step is required for every different process and different mark, taking in much time for evaluating the overlay error. There is still another drawback that, since the amount of expansion or contraction of the center-to-center distance of two pairs of marks displaced by design values of +1/4 pitch and -1/4 pitch might also result in measurement errors, the temperature at the time of measurement must be in agreement with high accuracy with the temperature at the time of exposure.
An object of the present invention, in consideration of the points described above, is to provide a positional information measuring technique that makes it possible to obtain easily information on the relative displacement of two marks when the scatterometry or reflectometry is used.
Another object of the present invention is to provide an exposure technique that makes it possible to evaluate errors in alignment or overlay using the scatterometry or reflectometry.

Means to solve the problems

A positional information measuring method according to the present invention comprises, in a positional information measuring method for obtaining information on a relative displacement of two marks, a first process (steps 102 to 105) of irradiating the two marks with a light beam, using as the two marks a first mark (25A; WM1; WM) and a second mark (28A; RM1; 55) having dif ferent pitches from each other, and detecting only diffracted light of a predetermined one order generated from the two marks or light comprised of light beams (22) generated from the two marks in a predetermined one direction wavelength by wavelength of a plural number of wavelengths; and a second process (step 106) of obtaining information on relative displacement of the two marks based on a detected result of the first process.
According to the above-mentioned present invention, the first and second marks are placed for example one over the other with at least parts of them overlapping. As diffracted light of a predetermined order or light beams in a predetermined direction, for example only reflected light generated from the two marks in the predetermined direction is separated and detected wavelength by wavelength of a plural number of wavelengths to measure reflectance for every wavelength (spectral reflectance). Since the first and second marks are different in pitch, reflectance distribution corresponding to moiré pattern formed by superposing the two marks is obtained wavelength by wavelength of a plural number of wavelengths by sequentially measuring the spectral reflectance at specified intervals along the measurement direction of the two marks. Here, since the pitch of the moiré pattern is greatly enlarged relative to the pitch of the original two marks and the phase of the moiré pattern changes by 360° according to the phase displacement for one pitch of one of the two marks, the relative displacement amount of the two marks is observed as enlarged. It is possible to easily obtain with the scatterometry method the information on the relative displacement or the amount of relative displacement by specifying the phase of the central position of the moiré pattern using for example the wavelength distribution of the highest contrast out of the reflectance distribution for the plural number of wavelengths.
According to this method, since for example only the central position of the moiré pattern needs to be specified, it is unnecessary to obtain, in advance in a preparatory process using a large number of samples, the relationship between the reflectance distribution and the relative displacement. Further, since only the light beam directed substantially in a specified direction needs to be received, it is also possible to focus the light from the two marks using a simple optical system and carry out image processing of the photographed signals.

Here, it may be arranged to direct a light beam vertically at the two marks and detect only the light reflected normally from the two marks. In this way, it is possible to detect information on the relative displacement of the two marks using the reflectometry method.

An example of pitch difference is about an extent of one pitch for the overall width in the measurement direction of those marks. This provides a moiré pattern of up to a maximum pitch of one period. It may also be arranged that the first and second marks are superposed in a symmetric shape. In this way, the reflectance distribution (or transmittance distribution) obtained by scatterometry with the entire mark produces a distinct moiré pattern.

As an example according to the present invention, the first mark (25A) is formed at a first layer on an object (W) and the second mark (28A) is formed at a second layer (27) above the object located apart from the object in a direction normal to the surface of the object. This constitution makes it possible to measure the overlay error of the second layer relative to the first layer.

As another example, the first mark (WM1; WM) is formed on the first object (W) and the second mark (RM1; 55) is formed on the second object (R; 54) placed apart from the first object in a direction normal to a surface of the first object. This constitution makes it possible to measure for example relative displacement amount of the mask and the substrate or the displacement of the substrate relative to the index mark of the substrate, and make alignment using the measured results.

The first process may include a step (step 103) of detecting only light based on a moiré pattern obtained by superposing the two marks.

Furthermore, as an example, the first process includes a step (step 103) of detecting the light wavelength by wavelength of the plural number of wavelengths generated from the two marks using a photoelectric sensor (20) having a plural number of picture elements arranged one-dimensionally, and a step (step 105) of relatively displacing the photoelectric sensor and the two marks in a measurement direction. These two processes make it possible to measure the reflectance distribution or transmittance distribution along the measurement direction of the two marks wavelength by wavelength.

Moreover, as still another example, the first process includes a step of detecting the light wavelength by wavelength of the plural number of wavelengths generated from the two marks using a photoelectric sensor (20A) having a plural number of picture elements arranged two-dimensionally. Using the two-dimensional photoelectric sensor as described above and directing a light beam only once at the two marks makes it possible to measure the reflectance distribution or transmittance distribution along the measurement direction wavelength by wavelength within a short period of time.

Next, a positional information measuring apparatus according to the present invention comprises, in a positional information measuring apparatus for obtaining information on a relative displacement of two marks, a spectral detection device (10; 10A) which irradiates the two marks with a light beam and detects diffracted light of a predetermined one order generated from the two marks or light comprised of light beams generated from the two marks in a predetermined one direction wavelength by wavelength of a plural number of wavelengths; and an operation device (8; 8A) which obtains information on relative displacement of the two marks based on a detected result of the spectral detection device, wherein the two marks are marks (25A; 28A) different in pitch from each other.

The present invention makes it possible to obtain information on a relative displacement of two marks using the scatterometry method.

In this case, the spectral detection device includes, as an example, a light receiving optical system (15 to 18) which receives the diffracted light or the light beams generated from the two marks, a spectral optical system (19) which separates the received light wavelength by wavelength of the plural number of wavelengths, and a photoelectric sensor (20; 20A) which photoelectric-converts the separated light through a plural number of picture elements arranged one-dimensionally or two-dimensionally. This makes it possible to carry out photoelectric conversion of light wavelength by wavelength efficiently.

An exposure method according to the present invention, comprises, in an exposure method of illuminating a first object (R) with an exposure beam and exposing a second object (W) with the exposure beam through the first object, a first process of placing a second mark (RM1; 55) in proximity to a first mark (WM1; WM) on the first object or the second object; a second process (steps 102-105) of irradiating the first mark and the second mark with a light beam and detecting only diffracted light of a predetermined one order generated from the two marks or light comprised of light beams generated from the two marks in a predetermined one direction wavelength by wavelength of a plural number of wavelengths; a third process (step 106) of obtaining information on relative displacement of the two marks based on a detected result of the second step; and a fourth step of aligning the first object and the second object with each other based upon the information obtained in the third step.

The present invention makes it possible to measure the relative displacement of the two marks using the scatterometry method and carry out alignment of at least one of the first and second objects according to the measurement result.

In this case, as an example, the first mark is a mark (WM1) on the first object, and the second mark is a mark (RM1) on the second object. This is an example of application of the present invention to a case of exposure for example in a proximity method. Since it is possible to directly measure the relative displacement between the first object and the second object, alignment can be made with high accuracy based on the measurement result.

Further, the first mark and the second mark may be different from each other in pitch. This makes it possible to easily detect the displacement amount between the first and second marks as enlarged in a moire pattern.

An exposure apparatus according to the present invention, comprises, in an exposure apparatus for illuminating a first object (R) with an exposure beam and exposing a second object (W) with the exposure beam through the first object, a spectral detection device (10; 10A) which irradiates, with a light beam, a first mark (WM1; WM) on the first object or the second object and a second mark (RM1; 55) placed in proximity to the first mark, and detects diffracted light of a predetermined one order generated from the two marks or light comprised of light beams generated from the two marks in a predetermined one direction wavelength by wavelength of a plural number of wavelengths; and an operation device (8; 8A) which obtains information on a relative displacement between the two marks based on a detected result of the spectral detection device. The present invention makes it possible to obtain information on the relative displacement between the two marks using the scatterometry method.

In this case, as an example, the exposure apparatus further comprises: an index member (54) on which the second mark (55) is formed; and a stage mechanism (48, 49) which places the second mark of the index member in proximity to the first mark. This makes it possible, when for example making alignment of the second object (substrate) on an image plane side of a projection optical system in a projection exposure apparatus, to measure the position of the first mark with reference to the second mark on the index member by moving the first mark on the second object toward the bottom surface side of the index member.

Furthermore, the first mark and the second mark may be different from each other in pitch. This makes it possible to easily detect the relative displacement between the first and second marks as enlarged in a moiré pattern.

A device manufacturing method according to the present invention is a device manufacturing method including a lithography process, wherein a device pattern (R) is transferred to a photosensitive object (W) using the exposure method according to the present invention in the lithography process. According to the present invention, devices are manufactured with high accuracy owing to improved overlay accuracy at the time of exposure.

Effect of the Invention

With the present invention, because the marks different from each other in pitch are used, when the scatterometry or reflectometry is used, it is possible to easily obtain information on the relative displacement between the two marks as enlarged for example in a moire pattern.

The present invention also makes it possible to form in advance two marks on different layers, so as to easily measure the overlay error of the two layers without making a preparatory step in particular.

The method and apparatus for exposure according to the present invention also make it possible to carry out alignment with high accuracy using the scatterometry or reflectometry.

Brief Description of the Figures in the Drawings

Fig. 1 is a diagram showing an apparatus according to a first embodiment of the present invention for measuring an overlay error.

Fig. 2 is a side view of a spectral reflectance detecting device 10 of Fig. 1 as seen in a +X-direction.

Fig. 3 is an enlarged sectional view of an essential part showing a mark constitution of two layers as a measurement object in Fig. 1.

Fig. 4 is a diagram showing an example of spectral reflectance obtained with the spectral reflectance detecting device 10 of Fig. 1.

Fig. 5 is a diagram showing a relationship of a relative displacement between the two marks 25A, 28A in Fig. 3 and a reflectance distribution at a wavelength obtained by regular reflection light.

Fig. 6(A) is a diagram showing a spectral reflectance detecting device 10A according to a second embodiment of the present invention, and Fig. 6(B) is a side view of Fig. 6(A).

Fig. 7 is a diagram showing an exposure device of a proximity type according to a third embodiment of the present invention.

Fig. 8 is a diagram showing a projection exposure device according to a fourth embodiment of the present invention.

Fig. 9 is a flowchart showing an example of an action in measuring a relative displacement amount of two marks in the first embodiment.

Best Mode for Carrying out the Invention

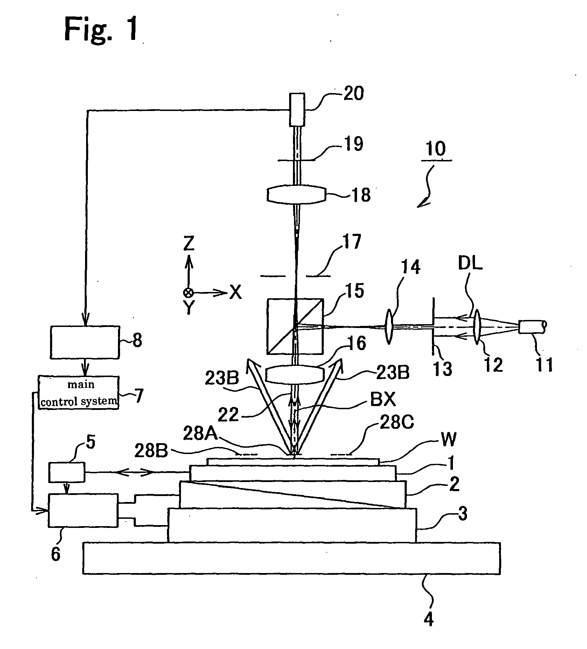

A preferable first embodiment of the present invention is described below in reference to Figs. 1 through 3, and 9. This example is an application of the present invention to the measurement of overlay error using the reflectometry as a type of the scatterometry.

Fig. 1 shows the embodiment, an apparatus for measuring the overlay error. As shown in Fig. 1, the second marks, or marks 28A, 28B, and 28C, are formed on the upper layer of a measurement object, a wafer W. The lower layers of these marks are respectively provided with first marks (not shown, to be described later in detail). This embodiment is assumed to measure the relative displacement amount of the central mark 28A on the upper layer corresponding to the central first mark on the lower layer. Relative displacement amounts of other pair of marks are measured likewise. Incidentally, while the pairs of marks are provided in three positions in this example, their layout and number may be arbitrary. The following description assumes the X-axis in the direction of measuring the relative displacement, the Y-axis in the direction vertical to the X-axis in a plane on which the wafer W is placed, and the Z-axis in the direction vertical to the plane on which the wafer W is placed.

First, the wafer W is held by vacuum suction through a wafer holder (not shown) on a wafer table 1. The wafer table 1 is fixed on a Z-stage 2 for controlling the position in the Z direction. The Z-stage 2 is fixed on an XY-stage 3. The XY-stage 3 is placed on a guide surface (parallel to the X-Y surface) of a high planar accuracy and approximately horizontal on a surface plate 4 to be movable in the X and Y directions. The XY-stage 3 is driven with a drive mechanism (not shown) including a drive motor, a ball screw, etc. in the X and Y directions on the surface plate 4.

The position of the wafer table 1 (wafer W) in the X and Y directions is measured with a laser interferometer 5 of resolution of for example about 10 to 1 nm. The rotary angle (yawing amount) of the wafer table 1 about the Z-axis is also measured. These measurements are supplied to a main control system 7 constituted with a computer and a stage drive system 6 for controlling the motion of the entire apparatus. The stage drive system 6 controls the position of the XY-stage 3 (wafer W) according to the measurements and control information from the main control system 7 through the drive mechanism. The stage drive system 6 also controls the height of the Z-stage 2 according to the control information from the main control system 7.

A spectral reflectance detecting device 10 is supported with a column (not shown) above the wafer table 1 of this embodiment, so that detection signals from the spectral reflectance detecting device 10 are supplied to a data processing device 8 constituted with a computer. The data processing device 8 obtains the relative displacement amount of the two layers on the wafer W as described later and supplies it to the main control system 7.

In the spectral reflectance detecting device 10, light emitted from a white color light source such as a halogen lamp (not shown) is guided through an optical fiber bundle 11. The light generated from the optical fiber bundle 11 passes through a filter plate (not shown) for wavelength screening to become a detection light DL of a wavelength range of about 300 to 1000 nm, and is condensed through a condenser lens 12 at an illumination field stop 13. The detection light DL coming out the stop of the illumination field stop 13 passes through a lens 14 and enters a beam splitter 15. The detection light DL reflected with the beam splitter 15 passes through a first objective lens 16 and is directed vertically upon the mark 28A on the upper layer of the measurement object on the wafer W. With this embodiment, since measurement is carried out by relatively moving (scanning) the detection light DL and the wafer W in the measurement direction (in the X direction in this embodiment), the illumination area of the detection light DL on the wafer W is narrowed to a circular spot area of about 1 to 10 $\mu$m in diameter.

Only the light 22 that is reflected substantially normally from the upper layer and the lower layer of the wafer W passes through the first objective lens 16, the beam splitter 15, and an aperture stop 17, to reach a second objective lens 18. The optical axis BX of the light receiving system or the image-forming optical system, made up of the first objective lens 16, the beam splitter 15, the aperture stop 17, and the second objective lens 18, is parallel to the Z-axis. Here, the light 23B, diffracted by reflection at the mark 28A and the first layer's mark and traveling in the measurement direction (X-direction) (reflection-diffracted light other than regular reflection light 22), does not enter the first objective lens 16 or stopped with the aperture stop 17. As described above, this embodiment uses the reflectometry method in which only the regular reflection light 22 from the wafer W has to be detected. Therefore, a simple optical system with the first and second objective lenses of the numerical aperture (NA) as small as for example about 0.1 may be used. The regular reflection light 22 having passed through the aperture stop 7 is concentrated with the second objective lens 18, travels through a diffraction grating 19 formed at specified pitches in the Y-direction, and forms the image of the circular spot area on the imaging plane of an image pickup element 20 of such a type as the one-dimensional CCD type. The diffraction grating 19 is preferably of a phase type, for example the blaze-of-grating type, in order to increase diffraction efficiency.

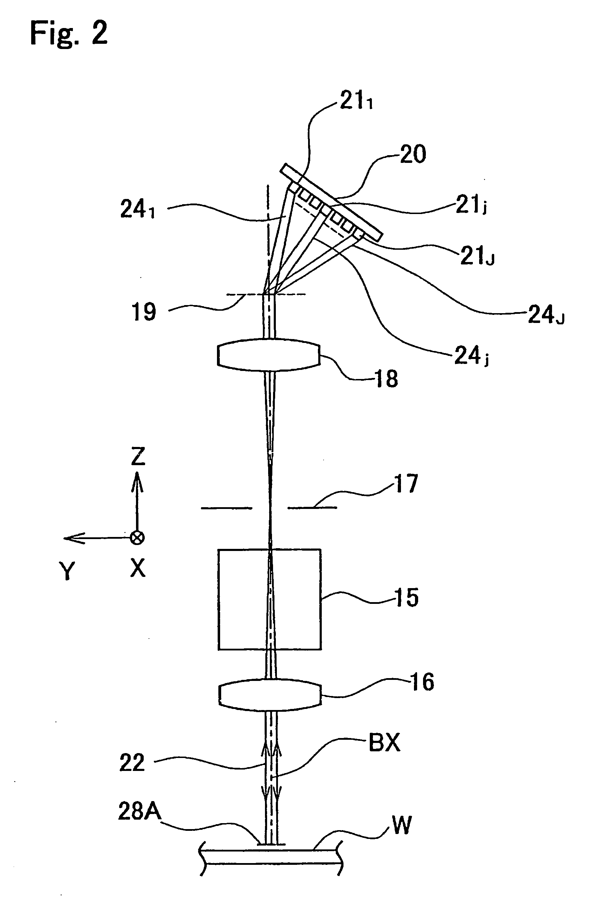

Fig. 2 is a side view of the spectral reflectance detecting device 10 as seen in the X-direction. In Fig. 2, the regular reflection light 22 concentrated with the second objective lens 18 is separated by wavelength for example by the primary diffraction with the diffraction grating 19 into J pieces of light beams $24_j$ (j = 1 - J). Assuming the wavelength range of the detection light DL (regular reflection light 22) to be $\lambda$1 - $\lambda$2, the central wavelength $\lambda$j of the J pieces of light beams $24_j$ and the separation width $\Delta\lambda$ are expressed approximately as follows:

$$\lambda j = \lambda 1 + (j - 1) \Delta\lambda \quad \ldots\ldots (1)$$

$$\Delta\lambda = (\lambda 2 - \lambda 1)/(J - 1) \quad \ldots (2)$$

The wavelength range of this example is 300 - 1000 nm. In case the number of wavelength separation J is assumed to be for example about 20 - 200, the wavelength separation width $\Delta\lambda$ is about 35 - 3.5 nm. Each of the separated J pieces of light beams $24_j$ strikes corresponding j-th picture element 21j of the image pickup element 20 and undergoes photoelectric conversion. Therefore, the image pickup element 20 of this example is a one-dimensional array of J pieces or more of picture elements. Each of detection signals having undergone photoelectric conversion at each picture element 21j (j = 1 - J) sequentially undergoes analog-digital (A/D) conversion in the data processing device 8 shown in Fig. 1 and stored in the first memory. In Fig. 2, for example a mirror (reference reflector) of a uniform and high reflectance is placed in advance in the position of the wafer W. In the state of the output of the detection light DL being set to the same level as that during measurement, the detection signal of each picture element $21_j$ of the image pickup element 20 is taken into the data processing device 8 and A/D-converted. The converted values are stored as reference data in a second memory. Then, the operation processing section in the data processing device 8 divides the detection signal of each picture element $21_j$ stored in the first memory by the reference data of each picture element $21_j$ stored in the second memory to obtain the reflectance R ($\lambda$j) of the regular reflection light 22 for every corresponding wavelength $\lambda$j. The reflectance R ($\lambda$j) for every wavelength $\lambda$j (spectral reflectance) isstoredinathirdmemory corresponding to the position in the X-direction of the mark 28A shown in Fig. 1 (for every relative position in the X-direction of the mark 28A and the detection light DL).

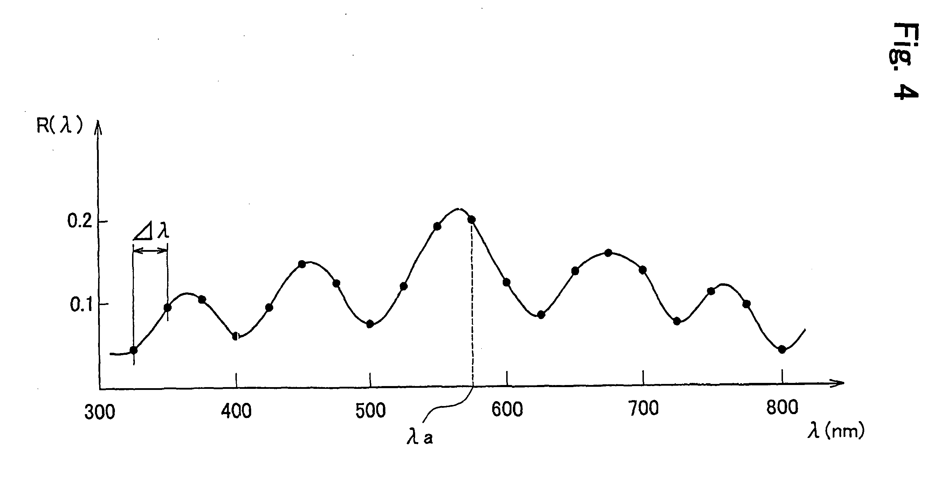

Fig. 4 shows an example of spectral reflectance at a certain position on the wafer W in the X-direction measured with the spectral reflectance detecting device 10. In Fig. 4, the lateral axis represents part of the wavelength $\lambda$(nm) of the detection light DL, and the vertical axis the reflectance R ($\lambda$) at the wavelength $\lambda$. In practice, as for the wavelength $\lambda$, the reflectance R ($\lambda$j) is measured at each of a plural number of wavelengths $\lambda$j as separated by the separation width $\Delta\lambda$. In this example, the reflectance distribution in the measurement direction of the regular reflection light 22 from the marks of the two layers is obtained by measuring the reflectance R($\lambda$a) for example at a wavelength $\lambda$a, at which the greatest reflectance values out of the plural number of reflectance values is obtained, along the measurement direction (X-direction) on the mark 28A.

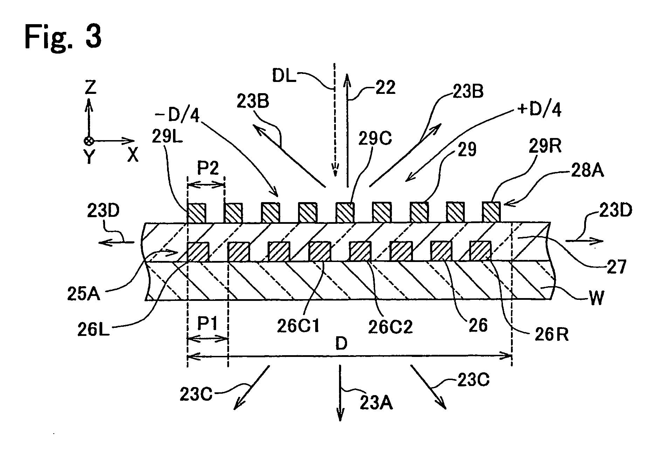

In order to explain the method of obtaining the relative displacement of the two marks from the reflectance distribution, the constitution of the two marks of this example is explained in reference to Fig. 3.

Fig. 3 is an enlarged sectional view showing the constitution of the mark 28A on the upper layer (hereinafter called as the second layer) of the wafer W shown in Fig. 1 and the mark 25A on the lower layer (hereinafter called as the first layer). In Fig. 3, the wafer W is for example a substrate of silicon (Si). In an area of width D in the X-direction on the surface as the first layer of the wafer W, a grating-like mark 25A is formed with raised parts 26 placed at pitches of P1 in the X-direction. A middle layer 27 as the second layer is formed to cover the mark 25A on the wafer W. In an area of width D in the X-direction on the middle layer 27, a grating-like mark 28A is formed with raised parts 29 placed at pitches of P2, slightly different from P1, in the X-direction. Here, the mark 25A of the first layer, the middle layer 27 as the second layer, and the mark 28A on the second layer are formed in a lithography process of the object of evaluation of the overlay error. The raised parts 29 constituting the mark 28A on the second layer are usually a photo resist pattern. Incidentally, while this embodiment is described below assuming that the mark has the raised parts 26, it is a matter of course that the present invention may be applied to the mark having recessed parts in place of the raised parts.

The raised parts 26 constituting the mark 25A of the first layer is made for example of silicon like the wafer W, or of metal such as titanium (Ti), tungsten (W), etc. In case the raised parts 26 are made of silicon, a thin layer of compound of silicon and metal (silicide) or a gate oxide film may be formed on the raised parts 26, depending on the case. The middle layer 27 in this example is a single layer or a plural number of layers of dielectric material that transmits at least part of the light within the wavelength range of the detection light DL from the spectral reflectance detecting device 10 as shown in Fig. 1. As such a dielectric layer, there may be for example a layer of an oxide film for STI (shallow trench isolation), polycrystalline silicon, silicon nitride (SiN), and ILD (inter-layer dielectrics). Further, in order to enhance the reflectance to the detection light DL, there may be cases in which it is necessary to form a an anti-reflection coating (an ARC) on the surface of the wafer W, on the surface inside the middle layer 27, or on the surface of the middle layer 27.

In order that the information on the relative displacement of the second layer's mark 28A to the first layer's mark 25A (information on the overlay error between the two layers) can be measured, it is necessary that: the condition of the expression (3) below is met, the diffracted light of other than the 0-th order generated from (coming out of) the second layer's mark 28A reaches the first layer's mark 25A, and inversely the diffracted light of other than the 0-th order generated from (coming out of) the first layer's mark 25A reaches the second layer's mark 28A. Here, $\lambda 1$ is the wavelength of the light in the air on the shortest wavelength side of the detection light DL, n is the minimum value of the refractive index of the middle layer 27 to the air, NA is the numerical aperture of the image-forming optical system including the first objective lens 16 and the second objective lens 18 shown in Fig. 1, and the pitch P is P1 or P2, whichever smaller.

$$(n + NA)P > \lambda1 \ldots (3)$$

If this condition is met, in Fig. 3, in addition to the diffracted light 23A of the 0-th order (transmission light) of the normal incident detection light DL, part of the transmission-diffracted light 23C of the first or greater order produced at (generated from) the second layer's mark 28A is diffracted nearly vertically upward at the first layer's mark 25A, which becomes the regular reflection light 22 from the detection object. While part of the 0-th order diffracted light 23A is diffracted with the first layer's mark 25A to become the reflection-diffracted light 23B of the first or greater order, the reflection-diffracted light 23B, as described above, is not detected with the spectral reflectance detecting device 10 shown in Fig. 1. On the other hand, in case the condition of the expression (3) is not met, the whole of the detection light DL incident to the second layer's mark 28A is attenuated in the middle layer 27 to become evanescent light 23D, and no information on the overlay error is obtained.

Next, example values of the pitch P1 of the mark 25A and the pitch P2 of the mark 28A are described. An advantage of the scatteromrtry is that measurements can be made with a mark having the same pitch as that of the device pattern. The pitch of the device pattern is assumed for example to be 200 nm. It is preferable that the widths D of the marks 25A and 28A in Fig. 3 in their measurement direction (X-direction) are about the same as or smaller than the width of the currently used mark, for example about 50 $\mu$m.

As a result, in Fig. 3, the pitch P1 of the first layer's mark 25A is 200 nm, 250 pieces of the raised parts 26 are placed within the width D, and so the following expression holds.

$$P1 = 50/250 \ (\mu m) = 200 \ (nm) \ \ldots (4)$$

Further, the second layer's mark 28A is made by placing 251 pieces of raised parts 29 within the width D. As a result, the pitch P2 of the mark 28A becomes slightly shorter than the pitch P1 as expressed below. Incidentally, in order to sufficiently meet the condition of the expression (3), the pitches P1 and P2 may be set as long as up to about 1 $\mu$m.

$$P2 = 50/251 \ (\mu m) \approx 199.2 \ (nm) \ \ldots (5)$$

In this case, the pitch PM in the measurement direction (X-direction) of the moiré pattern formed with the marks 25A and 28A of the two layers is as expressed below.

$$PM = P1 \cdot P2/(P1 - P2) \ \ldots (6)$$

Substituting the expressions (4) and (5) for the expression (6) results in the pitch PM of the moire pattern to be 50 $\mu$m, the same as the mark width D.

Fig. 3 shows a state of complete overlay of the first layer's mark 25A and the second layer's mark 28A. In other words, the raised parts 26L and 29L at the left ends of the marks 25A and 28A are substantially superposed, the raised part 29C in the center of the second layer's mark 28A is located between the two raised parts 26C1 and 26C2 in the center of the first layer's mark 25A, so that the mark is constituted in bilateral symmetry. With an origin assumed to be at the center of the mark 25A or 28A, in the area near the point apart by $\pm$D/4 (= 12.5 $\mu$m) from the origin along the X-axis, a situation occurs in which the second layer's mark 28A is displaced left or right by one-fourth of a pitch relative to the first layer's mark 25A, reflectance changes suddenly in this area, and the sensitivity of displacement of reflectometry comes to a maximum. Therefore, the distribution R(X) in the X-direction of the reflectance due to the regular reflection light 22 from the marks 25A and 28A of the two layers results in the distribution corresponding to the moiré pattern of a pitch of 50 μm.

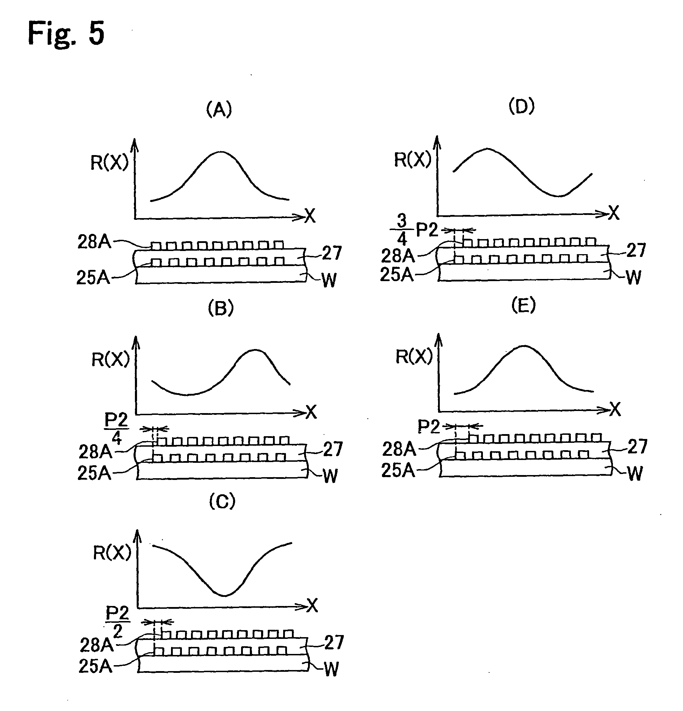

Figs. 5 (A) - 5(E) show the relationship of the relative displacement between the first layer's mark 25A and the second layer's mark 28A in Fig. 3 in the X-direction to the reflectance distribution R(X) in the X-direction at a wavelength of the regular reflection light from those marks. In other words, Fig. 5(A) shows a state in which the marks 25A and 28A are completely superposed, and the reflectance distribution R(X) obtained is of a sine wave shape in bilateral symmetry with a maximum in the center. Fig. 5(B) shows a state in which the second layer's mark 28A is displaced by one-fourth of a pitch (= P2/4) in the +X direction from the state of Fig. 5(A) and the reflectance distribution R(X) obtained is also displaced by one-fourth of a pitch (= D/4) in the +X direction from the distribution of Fig. 5(A). Likewise, Figs. 5(C), 5(D), and 5(E) show the states in which the second layer's mark 28A is displaced from the state of Fig. 5(A) in the +X direction respectively by 1/2 pitch (= P2/2), 3/4 pitch (= 3·P2/4), and 1 pitch (= P2). So the reflectance distributions R(X) obtained are also displaced from the distribution of Fig. 5(A) respectively by 1/2 pitch (180°, inversion of Fig. 5(A)), 3/4 pitch (3·D/ 4), and 1 pitch (360°, substantially identical to Fig. 5(A)).

In this way, the displacement amount of the mark 28A is enlarged, in the displacement amount of the moire pattern, to about D/P2 times (about 250 times in this example). Therefore, obtaining the displacement amount (phase) of the moiré pattern by detecting the reflectance distribution makes it possible to obtain the displacement amount of the second layer's mark 28A relative to the firs layer's mark 25A, or further the overlay error of the second layer relative to the first layer with high accuracy.

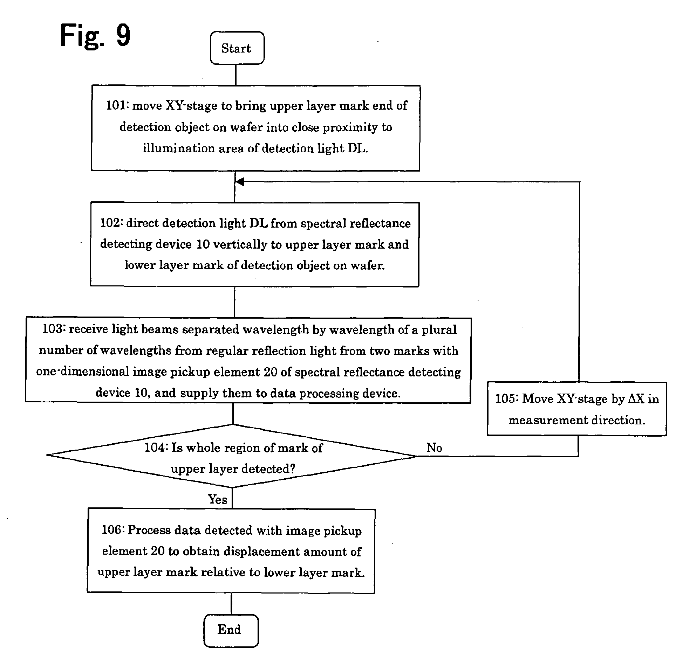

Here, example actions of actually measuring the relative displacement amount of twomarks using the spectral reflectance detecting device 10 of Fig. 1 are described in reference to the flowchart shown in Fig. 9. First, under the control of the main control system 7, in the step 101 of Fig. 9, the XY-stage 3 of Fig. 1 is driven to move the wafer table 1 (wafer W) so that the +X direction end of the mark 28A of the upper layer of the detection object of the wafer W comes close to, with an interval of about several μm, the -X direction end of the illumination area of the detection light DL from the spectral reflectance detecting device 10. To help do this, the positions in the X- and Y-directions of the marks 28A to 28C of the upper layer of the wafer W are obtained in advance with relatively rough accuracy of for example about 1 μm using for example a microscope or the like (not shown). In the next step 102, the detection light DL is irradiated from the spectral reflectance detecting device 10 vertically at the wafer W. Since the wafer W is moved gradually in the +X direction through the XY-stage 3 in this example as described later, the detection light DL gradually comes to be irradiated at the upper layer's mark 28A and the lower layer's mark 25A of Fig. 3.

In the next step 103, the image pickup element 20 of the spectral reflectance detecting device 10 of Fig. 1 receives light beams resulting from separation by picture element (by wavelength) of the light regular reflection light 22 from the two marks 25A and 28A, and signals obtained by detection are supplied to the data processing device 8. The data processing device 8 obtains spectral reflectance R(λj) (j = 1 - J) for every wavelength by dividing the detected signal obtained as described above for every picture element by reference data obtained in advance, and stores the results made to correspond to the position of the XY-stage 3 (wafer W) in the X-direction.

In the next step 104, whether the area including the whole width in the measurement direction (X-direction) of the second layer's mark 28A has been detected is determined. Since the width D in the measurement direction of the mark 28A of this example is 50 μm, it is enough to check as an example whether the wafer W has been displaced from the state of the step 101 in the +X direction by a distance of the width D plus about 10 μm. In case such an amount of displacement has not been made, the action goes to the step 105 in which the main control system 7 displaces the XY-stage 3 by a distance of ΔX (for example about 0.1 to 1 μm) in the +X direction as the measurement direction. After that, the action goes back to the steps 102 and 103 in which the detection light DL is irradiated from the spectral reflectance detecting device 10 vertically at the marks 25A and 28A on the wafer W, the image pickup element 20 receives the regular reflection light 22 from the marks 25A and 28A by wavelength, and the obtained detection signal are supplied to the data processing device 8. The actions of the steps 102 through 105 are repeated until the regular reflection light is received from the whole area in the measurement direction of the mark 28A. When the regular reflection light is received from the whole area, the action goes from the step 104 to the step 106.

The operation processing section of the data processing device 8, after receiving the detected signals from the image pickup element 20, obtains the displacement amount of the second layer's mark 28A in the X-direction relative to the first layer's mark 25A of Fig. 3 by processing the detection data obtained in advance by dividing by the reference data, or the spectral reflectance R(λj) stored in advance corresponding to the position of the wafer W in the X-direction. For that purpose, the operation processing section of the data processing device 8 specifies as an example a wavelength λj (assumed to be λa) of the highest reflectance in average out of the reflectance R(λj) obtained in advance for every position of the wafer W in the X-direction. Next, the operation processing section puts in order the reflectance R(λa) at the wavelength λa for every position of the wafer W in the X-direction to obtain the reflectance distribution R(λa, X). This reflectance distribution R(λa, X) results in the distribution that comes between any adjacent two of the reflectance distributions R(X) shown in Figs. 5(A) through 5(E). Therefore, it is possible for example by interpolation to obtain from the reflectance distribution R($\lambda$a, X) the displacement amount $\delta$XA (-P2/2 < $\delta$XA $\leq$ +P2/2) of the mark 28A in the X-direction relative to the mark 25A.

In this example, since the state in which the overlay error is zero is the state shown in Fig. 5(A), when the reflectance distribution R($\lambda$a, X) is within the range from Fig. 5(C) to Fig. 5(D) or from Fig. 5(D) to Fig. 5(E), the displacement amount $\delta$XA of the mark 28A is dealt with as being in the negative range (-P2/2 < $\delta$XA $\leq$ 0). In this way, measurement of the displacement of the mark 28A in the center of the second layer is completed. It is likewise possible to measure the displacement amounts of the other marks 28B and 28C relative to the first layer's mark. Then, the displacement amounts of the marks 28A to 28C are the overlay errors in the X-direction at the positions of respective marks of the second layer relative to the first layer.

Since the embodiment as described above measures the relative displacement amount between the two marks using the reflectometry as a type of the scatterometry, the image-forming optical system in the spectral reflectance detecting device 10 as the light receiving optical system may be made simple in constitution having a small numerical aperture. Moreover, the measurements are little affected with the aberration of the image-forming optical system or with the asymmetry of the marks 25A and 28A of the two layers. Still another advantage is that, since only the regular reflection light 22 from the marks 25A and 28A that are made as a single set, is received, the measurement results of the relative displacement amounts are little affected with, if any vibration of the XY-stage 3 while the measurements are being made.

While the above embodiment is assumed to use the detection light DL from the spectral reflectance detecting device 10 and the XY-stage 3 (stage mechanism) for relatively displacing the marks 25A and 28A in the measurement direction, otherwise, the wafer W may be scanned in the measurement direction with the detection light DL using an oscillation mirror or the like.

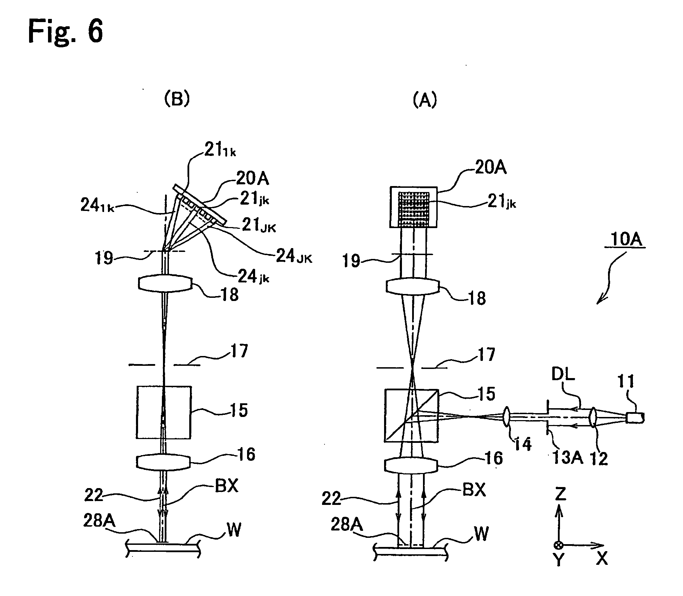

Next, the second embodiment of the present invention is described in reference to Fig. 6. This example is the one in which two-dimensional image pickup element is used in place of the one-dimensional image pickup element 20 in the spectral reflectance detecting device 10 shown in Fig. 1. In Fig. 6, components corresponding to those in Figs. 1 and 2 are provided with the same or like reference numerals and symbols, and their descriptions are not repeated.

Fig. 6(A) shows a spectral reflectance detecting device 10A of this embodiment. Fig. 6(B) is a side view of Fig. 6(A). An illumination field stop 13A shown in Figs. 6(A) and 6(B) is set to illuminate a wider area on the wafer W in comparison with the illumination field stop 13 shown in Fig. 1. That is, the detection light DL of this example illuminates an area that covers the entire width (50 $\mu$m in this example) in the measurement direction (X-direction) of the mark 28A of the second layer on the wafer W, for example an illumination area of about a width of 100 $\mu$m in the X-direction and about a width of 10 $\mu$m in the Y-direction. Further, the image pickup element 20A of this example is a two-dimensional array of a plural number of picture elements $21_{jk}$ (j = 1 to J, k = 1 to K), J pieces in about the Y-direction (J equal to about 20 to 200) and K pieces in the X-direction (K equal to about 100 to 500). Assuming K to be 100, the resolution of the mark image in the measurement direction comes to 1 $\mu$m. Otherwise the constitution remains similar to that of the embodiment shown in Fig. 1.

In this example, the regular reflection light 22 resulting from the detection light DL incident vertically to cover the whole width in the measurement direction of the mark 28A of the upper layer of the wafer W is concentrated with an image-forming optical system made up of the first objective lens 16, the beam splitter 15, the aperture stop 17, and the second objective lens 18. The regular reflection light 22 concentrated as described above is separated with the diffraction grating 19 by wavelength and received with respective picture elements $21_{jk}$ of the image pickup element 20A. Also in this embodiment, reference data for respective picture elements $21_{jk}$ are obtained in advance by receiving regular reflection light 22 from a mirror (reference reflection object) placed in place of the wafer W, and stored in a processing device corresponding to the data processing device 8 shown in Fig. 1. In the processing device, reflectances Rjk are obtained by dividing the detection signals of respective picture elements $21_{jk}$ by their reference data. Of the reflectances Rjk, those corresponding to the picture elements $21_{jk}$ (j = 1 to J) in the k-th row (k = 1 to K) in the X-direction and placed in about the Y-direction correspond to the reflectances R(X) (spectral reflectances) for respective wavelengths shown in Fig. 4 for respective positions of the wafer W in the X-direction. This means that the spectral reflectance values of respective positions in the measurement direction of the mark 28A are obtained by a single action of photographing.

Measurement of the displacement amount of the second layer's mark 28A in the X-direction relative to the first layer's mark using the data of the reflectances Rjk may be made, for example like the first embodiment, by specifying the wavelength of the highest reflectance (assuming j = a) out of the spectral reflectances Rjk (j = 1 to J) for respective positions in the X-direction. The reflectance distribution R(X) in the measurement direction is obtained by placing the reflectances Rak at that wavelength along the respective positions (k = 1 to K). Therefore, like the first embodiment, it is possible using the reflectometry method to obtain the displacement amount of the mark 28A relative to the mark 25A from the reflectance distribution R(X) and further to obtain the overlay error of the second layer relative to the first layer.

Since this embodiment here uses the two-dimensional image pickup element 20A, the spectral reflectance detecting device 10A and the wafer W need not make relative displacement mechanically in the measurement direction, the overlay error between the two layers is obtained with high accuracy and efficiency.

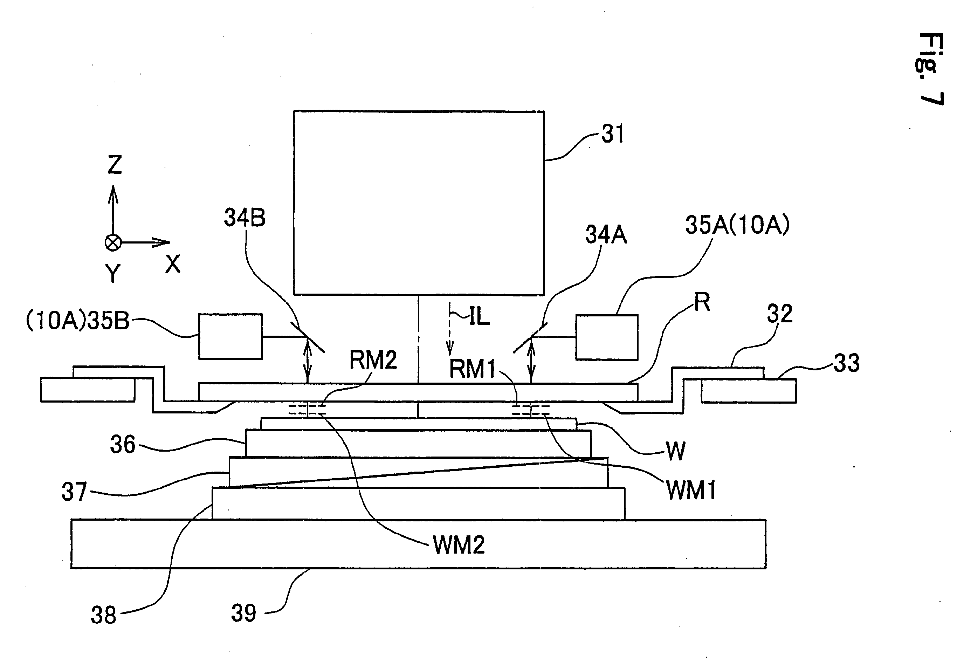

Next, the third embodiment of the present invention is described in reference to Fig. 7. This example is an application of the invention to a case in which alignment is made using an exposure device of the proximity type.

Fig. 7 shows the exposure device of the proximity type of this example. At the time of exposure in the state shown in Fig. 7, an exposure light IL (exposure beam) from an exposure light source (not shown) for example of KrF excimer laser (of a wavelength of 248 nm) with even luminance distribution illuminates a pattern area of the pattern surface (underside) of the reticle R as a mask, through an illumination optical system 31. The illumination optical system 31 is made up of: an optical integrator for making even the luminance distribution, a field stop (reticle blind) for defining the illumination area, a condenser lens, etc.

Under the exposure light IL, a circuit pattern on the reticle R is projected to the wafer W as a substrate on which photoresist is applied. Incidentally, a glass plate on which photoresist is applied may be also used besides the wafer W. In the following description, the Z-axis is defined parallel to the optical axis of the illumination optical system 31, the X-axis parallel to the paper sheet surface of Fig. 7 in a plane vertical to the Z-axis, and the Y-axis vertical to the paper sheet surface of Fig. 7.

At this time, the reticle R is suctioned and held on a reticle stage 32. The reticle stage 32 is placed on a reticle base 33 to be fine adjusted with a drive mechanism (not shown) in the X-direction, Y-direction, and rotary direction about the Z-axis. The positions in the X- and Y-directions and rotary angle about the Z-axis of the reticle stage 32 are measured with a laser interferometer (not shown) with resolution of for example about 1 nanometer.

On the other hand, the wafer W is held by vacuum suction on the wafer table 36 through a wafer holder (not shown). The wafer table 36 is secured on a Z-stage 37 for controlling the position in the Z-axis. The Z-stage 37 is secured onanXY-stage 38. The XY-stage 38 is placed on a wafer base 39 made of a surface plate to be movable in the X- and Y-directions through air bearings. The positions in the X- and Y-directions and rotary angle about the Z-axis of the wafer table 36 (wafer W) are measured with a laser interferometer (not shown) with resolution of for example about 1 nanometer. The XY-stage 38 is driven with a drive mechanism (not shown) according to the measurement results.

Now, assuming that this exposure is overlay exposure, the reticle R and the wafer W must be aligned in advance before the exposure. For that, alignment marks (reticle marks) RM1 and RM2 are provided in two positions near the pattern area of the pattern surface of the reticle R. Also on the wafer W, alignment marks (wafer marks) WM1 and WM2 are provided corresponding to the counterparts of the reticle R. Besides, the positions of the two reticle marks RM1 and RM2 are assumed to be greatly displaced in the Y-direction. In this example too, the pitch of the reticle marks RM1 and RM2 is slightly different from the pitch of the wafer marks WM1 and WM2. An alignment sensor 35A of the same constitution as that of the spectral reflectance detecting device 10A shown in Fig. 6 is placed above the wafer mark WM1 and the reticle mark RM1 on one side through a mirror 34A for bending the optical path. Also above the wafer mark WM2 and the reticle mark RM2 on one side, an alignment sensor 35B of the same constitution as that of the spectral reflectance detecting device 10A shown in Fig. 6 is placed through a mirror 34B for bending the optical path.

In this example, the alignment sensors 35A and 35B respectively measure the displacement amounts in the measurement direction (for example in the X-direction) of the reticle marks RM1 and RM2 relative to the wafer marks WM1 and WM2 using the reflectometry method. At this time, the gap between the pattern surface of the reticle R and the top surface of the wafer W is for example about 10 μm, so that little attenuation of the detection light occurs across that gap. Therefore, it is possible to measure the displacement amount between the two marks, upper and lower, with high accuracy using the simple optical systems, the alignment sensors 35A and 35B.

Besides, though not shown, actually reticle marks and wafer marks slightly different in pitch for measuring the displacement amounts of the reticle R and the wafer W in the Y-direction are also formed and alignment sensors of the same constitution as that of the spectral reflectance measuring apparatus 10A shown in Fig. 6 are provided for measuring the displacement between these marks in the Y-direction. On the basis of these measurements, it is possible to project the pattern of the reticle R onto the wafer W with the wafer W and the reticle R in positional agreement with high accuracy.

Besides, this example may be made that the pitch of the reticle marks RM1 and RM2 is the same as the pitch of the wafer marks WM1 and WM2. This may be arranged for example that: the wafer mark WM1 is divided into two marks, the reticle mark RM1 is divided in advance into two marks different in design value by +1/4 pitch and -1/4 pitch, and the displacement amount of the reticle mark relative to the wafer mark is measured from the spectral reflectance obtained on the basis of the regular reflection light from the two pairs of marks.

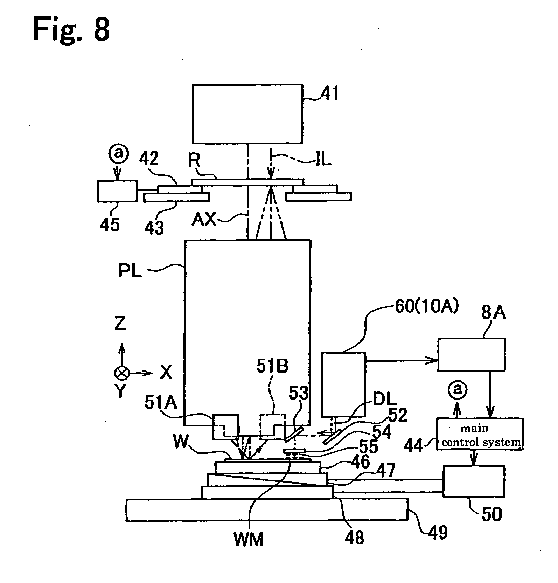

Next, the fourth embodiment of the invention is described in reference to Fig. 8. This example is an application of the present invention to the case in which the wafer is aligned using a projection exposure device.

Fig. 8 shows a scanning type of projection exposure device for use in this example. In Fig. 8, an exposure light IL (exposure beam) from an exposure light source (not shown) such as an excimer laser light source using for example KrF or ArF (of a wavelength of 193 nm) illuminates with even luminance distribution an elongated illumination area of the pattern surface of the reticle R serving as a mask (first object) through an illumination optical system 41.

Under the exposure light IL, an image of part of the circuit pattern on the reticle R is projected to an elongated exposure area on one shot area on the wafer W serving as a substrate (second object) through a bi-telecentric projection optical system PL at a projection magnification of β (β being 1/5, 1/4, etc.). The wafer W is for example a disk-like substrate of about 150 to 300 mm in diameter of semiconductor (silicon, etc.) or SOI (silicon on insulator), with its surface applied with photoresist. In the following description, the Z-axis is defined parallel to the optical axis AX of the projection optical system PL, X-axis parallel to the paper sheet surface of Fig. 8 in a plane vertical to the Z-axis, and the Y-axis vertical to the paper sheet surface of Fig. 8. The scanning direction of the reticle R and the wafer W at the time of scanning exposure in this embodiment is the Y-direction.

At this time, the reticle R is suctioned and held on a reticle stage 42. The reticle stage 42 is placed on a reticle base 43 so as to be driven at a constant speed in the Y-direction through air bearings, and to be fine adjusted in the X-direction, Y-direction, and rotary direction about the Z-axis. Positions of the reticle stage 42 in the X- and Y-directions and its rotary angle are measured with a laser interferometer provided in a reticle stage drive system 45. On the basis of these measurements and control information from a main control system 44 made of a computer for controlling the actions of the entire apparatus, the reticle stage drive system 45 controls the speed and position of the reticle stage 42 through a drive mechanism (not shown) such as a linear motor.

On the other hand, the wafer W is held on a wafer table 46 by vacuum suction through a wafer holder (not shown). The wafer table 46 is secured onto a Z-tilt stage 47 for controlling the position in the Z-direction and the tilt angles about the X- and Y-axes. The Z-tilt stage 47 is secured onto an XY-stage 48. The XY-stage 48 is placed on a wafer base 49 made of a surface plate through air bearings to be movable at a constant speed in the Y-direction, and to be movable stepwise in the X- and Y-directions. On the lower side face of the projection optical system PI is disposed a multipoint auto-focus sensor of an oblique incident type made up of: a projection optical system 51A for obliquely projecting an image of a plural number of slits onto the surface of the wafer W, and a light receiving optical system 51B for receiving the light reflected from the wafer W to re-form the slit image and for outputting a signal corresponding to the shift amount of the re-formed image. At the time of scanning exposure, the wafer W's surface is brought into agreement with the image surface of the projection optical system PL according to the measurements obtained with the auto-focus sensor.

Positions of the wafer table 46 (wafer W) in the X- and Y-directions and its rotary angle are measured with a laser interferometer provided in a wafer stage drive system 50 with a resolution of for example about 1 nanometer. On the basis of these measurements and control information from the main control system 44, the wafer stage drive system 50 controls speed and position of the XY-stage 48 through a drive mechanism (not shown) such as a linear motor.

At the time of scanning exposure of the wafer W, the following actions are repeated: The reticle stage 42 and the XY-stage 48 are driven to synchronously scan the reticle R and a single shot area on the wafer W in the Y-direction for the illumination area of the exposure light IL and an exposure area conjugate to it for the projection optical system PL, and the XY-stage 48 is driven to move the wafer W stepwise in the X- and Y-directions. With the above actions, the pattern image of the reticle R is exposed on respective shot areas on the wafer W by a step-and-scan method.

Now, assuming that this exposure is overlay exposure, the reticle R and the wafer W must be aligned in advance before the exposure. For that, a reticle alignment microscope (not shown) disclosed for example in Japanese patent application publication laid-open No. 7-176468 is placed above the reticle R. A wafer mark WM serving as an alignment mark is provided in each of the shot areas on the wafer W. For detecting the position of the wafer mark, an alignment sensor 60 of an off-axis type and the same in constitution as the spectral reflectance detecting device 10A shown in Fig. 6 (with the measurement direction set in the X-direction) is placed on the side face of the projection optical system PL. Besides, for measuring the position of the wafer mark WM in the X- and Y-directions, an Y-axis sensor of a constitution in which the spectral reflectance detecting device 10A shown in Fig. 6 is turned by 90 degrees is also provided within the alignment sensor 60. Signals detected with the alignment sensor 60 are processed with a data processing device 8A and measured for the positions of the wafer mark WM, and the results are supplied to the main control system 44.

Since the alignment sensor 60 of this example is of the reflectometry type, a mark to be the reference (index mark) for measuring the position of the wafer mark WM is required. Therefore, an index plate 54 permitting light transmission is supported with a column (not shown) near the lower end of the projection optical system PL. The underside of the index plate 54 is provided with an index mark 55. The pitch of the index mark 55 is slightly different from that of the wafer mark WM. In constitution, non of the optical systems is interposed between the index plate 54 and the wafer. Besides, mirrors 52 and 53 for bending the optical path are provided to irradiate detection light from the alignment sensor 60 vertically to the index plate 54.

With this example, a reference mark member (not shown) provided with a reference mark like the wafer mark WM is placed near the wafer W on the wafer table 46. The reference mark is moved in advance to the bottom surface of the index mark 55 and then the displacement amount of the indexmark 55 relative to the reference mark is measured according to the reflectometry method using the alignment sensor 60. Based on the displacement amount, a baseline amount of the alignment sensor 60 is obtained in advance. When the position of the wafer mark WM on the wafer W is to be measured, the XY-stage 48 is driven to move the wafer mark WM to the bottom surface of the index mark 55. After that, the alignment sensor 60 and the data processing device 8A make the same action as the sequence shown in Fig. 9 to obtain the displacement amounts in the X-and Y-directions of the wafer mark WM relative to the index mark 55. Likewise, displacement amounts of other specified number of points on the wafer W are obtained. Based on the measured results, the main control system 44 aligns the wafer W.

Also in this example, the pitch of the wafer mark WM may be the same as that of the index mark 55.

The above embodiment makes measurements by the reflectometrymethod in which the detection light is irradiated from the spectral reflectance detecting device 10, 10A vertically to the mark as measurement objects, and the regular reflection light is detected. Besides, the present invention may be applied to the case of measuring the displacement amounts of marks by the general scatterometry method in which reflected light or diffracted light of specified order generated from the measurement objects or marks in an oblique, specified direction is detected, or reflected light or diffracted light produced in a specified direction by irradiating detection light obliquely at the measurement objects or the marks is detected.

The exposure device and the projection exposure device of the above embodiment may be manufactured by installing an illumination optical systemmade up of a plural number of lenses into the main part of the exposure device and making optical adjustments, attaching the reticle stage and the wafer stage made up of a large number of mechanical parts to the main part of the exposure device, and making further adjustments (electric adjustments, action checkups, etc.). The manufacture of the exposure device is preferably carried out in a clean room where the temperature, cleanliness, etc. are controlled.

When semiconductor devices are manufactured using the projection exposure device of the above embodiment, the manufacture of the semiconductor devices is carried out through the following steps: designing function and performance of the devices, manufacturing reticles as specified in the design step, forming wafers from silicon material, making alignment using the projection exposure device of the above embodiment and exposing the reticle pattern onto the wafers, forming circuit patterns by etching or the like, assembling the devices (including dicing, bonding, packaging, etc.), and inspection.

Incidentally, the present invention may also be applied in a similar manner to a batch exposure type of projection exposure device. The present invention may further be applied to the case of making alignment using a liquid immersion type of exposure device disclosed for example in an International Patent Application Laid Open No. WO 99/49504.

The use application of the present invention is not limited to the exposure device for manufacturing the semiconductor devices but may widely include for example exposure devices for display devices such as the liquid crystal display element formed on a square glass plate or the plasma display, and exposure devices for manufacturing various devices such as image pickup elements (CCD, etc.), micro-machines, thin-film magnetic heads, and DNA chips. The present inventionmay be further applied to the exposure process when manufacturing masks (such as the photo-mask and reticles) formed with mask patters of various devices using the photo-lithography process.

The present invention is not limited to the above-mentioned embodiments, and the invention may, as a matter of course, be embodied in various forms without departing from the gist of the present invention. Furthermore, the entire disclosure of Japanese Patent Application 2003-151703 filed on May 28, 2003 including description, claims, drawings and abstract are incorporated herein by reference in its entirety.

Industrial Applicability

When the present invention is applied to exposure methods or device manufacturing methods, alignment is made with high accuracy using the scatterometry or reflectometry, with high overlay accuracy, making it possible to manufacture various devices with high accuracy.

**Claims**

1. A positional information measuring method for obtaining information on a relative displacement of two marks, comprising:

   a first step of irradiating the two marks with a light beam, using a first mark and a second mark having different pitches from each other as the two marks, and detecting only diffracted light of a predetermined one order generated from the two marks or light comprised of light beams generated from the two marks in a predetermined one direction wavelength by wavelength of a plural number of wavelengths; and
   a second step of obtaining information on relative displacement of the two marks based on a detected result of the first step.

2. A positional information measuring method as recited in claim 1, wherein
   the first mark is formed at a first layer on an object and the second mark is formed at a second layer above the object located apart from the object in a direction normal to the surface of the object.

**3.** A positional information measuring method as recited in claim 1, wherein
the first mark is formed on the first object and the second mark is formed on the second object placed apart from the first object in a direction normal to a surface of the first object.

**4.** A positional information measuring method as recited in any one of claims 1 to 3, wherein
the first step includes a step of detecting only light based on a moiré pattern obtained by superposing the two marks.

**5.** A positional information measuring method as recited in any one of claims 1 to 3, wherein
the first step includes a step of detecting the light wavelength by wavelength of the plural number of wavelengths generated from the two marks using a photoelectric sensor having a plural number of picture elements arranged one-dimensionally, and a step of relatively displacing the photoelectric sensor and the two marks in a measurement direction.

**6.** A positional information measuring method as recited in any one of claims 1 to 3, wherein
the first step includes a step of detecting the light wavelength by wavelength of the plural number of wavelengths generated from the two marks using a photoelectric sensor having a plural number of picture elements arranged two-dimensionally.

**7.** A positional information measuring apparatus for obtaining information on a relative displacement of two marks, comprising:

a spectral detection device which irradiates the two marks with a light beam and detects diffracted light of a predetermined one order generated from the two marks or light comprised of light beams generated from the two marks in a predetermined one direction wavelength by wavelength of a plural number of wavelengths; and
an operation device which obtains information on relative displacement of the two marks based on a detected result of the spectral detection device, wherein
the two marks are marks different in pitch from each other.

**8.** A positional information measuring apparatus as recited in claim 7, wherein
the spectral detection device includes a light receiving optical system which receives the diffracted light or the light beams generated from the two marks, a spectral optical system which separates the received light wavelength by wavelength of the plural number of wavelengths, and a photoelectric sensor which photoelectric-converts the separated light through a plural number of picture elements arranged one-dimensionally or two-dimensionally.

**9.** An exposure method of illuminating a first object with an exposure beam and exposing a second object with the exposure beam through the first object, comprising:

a first step of placing a second mark in proximity to a first mark on the first object or the second object;
a second step of irradiating the first mark and the second mark with a light beam and detecting only diffracted light of a predetermined one order generated from the two marks or light comprised of light beams generated from the two marks in a predetermined one direction wavelength by wavelength of a plural number of wavelengths;
a third step of obtaining information on relative displacement of the two marks based on a detected result of the second step, and
a fourth step of aligning the first object and the second object with each other based upon the information obtained in the third step.

**10.** An exposure method as recited in claim 9, wherein
the first mark is a mark on the first object and the second mark is a mark on the second object.

**11.** An exposure method as recited in claim 9 or 10, wherein
the first mark and the second mark are different from each other in pitch.

**12.** An exposure apparatus for illuminating a first object with an exposure beam and exposing a second object with the exposure beam through the first object, comprising:

a spectral detection device which irradiates, with a light beam, a first mark on the first object or the second object and a second mark placed in proximity to the first mark, and detects diffracted light of a predetermined one order generated from the two marks or light comprised of light beams generated from the two marks in a predetermined one direction wavelength by wavelength of a plural number of wavelengths; and
an operation device which obtains information on a relative displacement between the two marks based on a detected result of the spectral detection device.

13. An exposure apparatus as recited in claim 12, further comprising:

an index member on which the second mark is formed; and
a stage mechanism which places the second mark of the index member in proximity to the first mark.

14. An exposure apparatus as recited in claim 12 or 13, wherein
the first mark and the second mark are different from each other in pitch.

15. A device manufacturing method including a lithography process, wherein
a device pattern is transferred to a photosensitive object using the exposure method as recited in claim 9 or 10 in the lithography process.

# Fig. 1

# Fig. 2

Fig. 3

# Fig. 4

# Fig. 5

(A)

(D)

(B)

(E)

(C)

# Fig. 6

(B)

(A)

$21_{1k}$
$24_{1k}$
20A
$21_{jk}$
$21_{JK}$
$24_{JK}$
19
$24_{jk}$
18
17
15
16
22
BX
28A
W

20A
$21_{jk}$
19
18
17
15
DL
11
16
14
13A 12
22
BX
28A
W

10A

Z
Y X

# Fig. 7

# Fig. 8

# Fig. 9

Start

101: move XY-stage to bring upper layer mark end of detection object on wafer into close proximity to illumination area of detection light DL.

102: direct detection light DL from spectral reflectance detecting device 10 vertically to upper layer mark and lower layer mark of detection object on wafer.

103: receive light beams separated wavelength by wavelength of a plural number of wavelengths from regular reflection light from two marks with one-dimensional image pickup element 20 of spectral reflectance detecting device 10, and supply them to data processing device.

105: Move XY-stage by ΔX in measurement direction.

104: Is whole region of mark of upper layer detected? — No

Yes

106: Process data detected with image pickup element 20 to obtain displacement amount of upper layer mark relative to lower layer mark.

End

## INTERNATIONAL SEARCH REPORT

| International application No. |
|---|
| PCT/JP2004/007276 |

**A. CLASSIFICATION OF SUBJECT MATTER**
    Int.Cl⁷ H01L21/027, G01B11/00

According to International Patent Classification (IPC) or to both national classification and IPC

**B. FIELDS SEARCHED**

Minimum documentation searched (classification system followed by classification symbols)
    Int.Cl⁷ H01L21/027, G01B11/00

Documentation searched other than minimum documentation to the extent that such documents are included in the fields searched
   Jitsuyo Shinan Koho        1922–1996   Toroku Jitsuyo Shinan Koho   1994–2004
   Kokai Jitsuyo Shinan Koho   1971–2004   Jitsuyo Shinan Toroku Koho   1996–2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2003-68639 A  (Nikon Corp.),<br>07 March, 2003 (07.03.03),<br>Par. Nos. [0020] to [0029], [0033] to [0035];<br>Figs. 2, 3, 6, 7<br>& US 2002/192577 A1 | 9,12,15<br>1-8,10,11,<br>13,14 |
| A | JP 2002-162368 A  (Nikon Corp.),<br>07 June, 2002 (07.06.02),<br>Par. Nos. [0060] to [0071]; Fig. 13;<br>Par. Nos. [0101] to [0111]<br>& US 2002/93647 A1      & TW 512229 A | 1-15 |
| X | JP 8-288197 A  (Nikon Corp.),<br>01 November, 1996 (01.11.96),<br>Par. Nos. [0035] to [0058]; Fig. 5<br>& US 6034378 A       & US 6242754 B1 | 1,3,7,9-15 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>    24 August, 2004 (24.08.04) | Date of mailing of the international search report<br>    07 September, 2004 (07.09.04) |
|---|---|
| Name and mailing address of the ISA/<br>    Japanese Patent Office | Authorized officer |
| Facsimile No. | Telephone No. |

Form PCT/ISA/210 (second sheet) (January 2004)

**INTERNATIONAL SEARCH REPORT**

| International application No. |
| --- |
| PCT/JP2004/007276 |

C (Continuation).    DOCUMENTS CONSIDERED TO BE RELEVANT

| Category* | Citation of document, with indication, where appropriate, of the relevant passages | Relevant to claim No. |
| --- | --- | --- |
| X | JP 3-67103 A (Canon Inc.), 22 March, 1991 (22.03.91), Claims 1, 2; Fig. 1; page 3, upper right column, to page 5, upper right column & EP 411966 A2          & US 5114236 A | 9,10,12,13, 15 |

Form PCT/ISA/210 (continuation of second sheet) (January 2004)

**INTERNATIONAL SEARCH REPORT**

| International application No. |
| --- |
| PCT/JP2004/007276 |

**Box No. II      Observations where certain claims were found unsearchable (Continuation of item 2 of first sheet)**

This international search report has not been established in respect of certain claims under Article 17(2)(a) for the following reasons:

1. ☐  Claims Nos.:
because they relate to subject matter not required to be searched by this Authority, namely:

2. ☐  Claims Nos.:
because they relate to parts of the international application that do not comply with the prescribed requirements to such an extent that no meaningful international search can be carried out, specifically:

3. ☐  Claims Nos.:
because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:

    Scatterometry is a publicly known position information measuring technology.
    Claims 1-8 involve inventions having the same technical feature in that
marks with different pitches are used in scatterometry.
    Claims 9-15 involve inventions having the same technical feature in that
scatterometry is applied in determining position information at exposing.

1. ☐  As all required additional search fees were timely paid by the applicant, this international search report covers all searchable claims.

2. ☒  As all searchable claims could be searched without effort justifying an additional fee, this Authority did not invite payment of any additional fee.

3. ☐  As only some of the required additional search fees were timely paid by the applicant, this international search report covers only those claims for which fees were paid, specifically claims Nos.:

4. ☐  No required additional search fees were timely paid by the applicant.   Consequently, this international search report is restricted to the invention first mentioned in the claims; it is covered by claims Nos.:

**Remark on Protest**       ☐   The additional search fees were accompanied by the applicant's protest.

☐   No protest accompanied the payment of additional search fees.

Form PCT/ISA/210 (continuation of first sheet (2)) (January 2004)